# EUROPEAN PATENT SPECIFICATION

(11) **EP 1 482 076 B1**
(45) Date of publication and mention of the grant of the patent: **22.07.2009**
(21) Application number: 04011295.5
(22) Date of filing: 12.05.2004
(51) Int. Cl.: C23C 30/00, C23C 14/06

(54) **Hard coating for cutting tool**
Harte Schicht für Schneidwerkzeug
Couche dure pour outil de coupe.

(30) Priority: 30.05.2003 JP 2003154069
(43) Date of publication of application: 01.12.2004
(73) Proprietor: UNION TOOL CO., Tokyo (JP)
(72) Inventor: Wakui, Hideo, Settaya Nagaoka-shi Niigata (JP); Sato, Akira, Settaya Nagaoka-shi Niigata (JP); Mezaki, Shunsuke, Settaya Nagaoka-shi Niigata (JP)
(74) Representative: Grünecker, Kinkeldey, Stockmair & Schwanhäusser Anwaltssozietät

(56) References cited:
- EP-A- 1 219 723
- DATABASE WPI Section Ch, Week 198409 Derwent Publications Ltd., London, GB; Class L02, AN 1984-054301 XP002297636 & SU 959 344 A (ANDREEV A A) 23 May 1983 (1983-05-23)

## Description

### Technical Field of the Invention

The present invention relates to a coating film for a cutting tool for use in cutting high hardness steel.

### Prior Art and Problems to be solved by the Invention

Conventionally, TiN and TiCN have been used as a hard anti-wear coating film (hereinafter simply referred to as a hard coating film) for coating a metal cutting tool. However, recently, a TiAlN system coating film representatively disclosed in Japanese Patent Application Nos. Sho 62-56565 and Hei 2-194159 has been developed as a hard coating film which is much superior in anti-oxidation property and it becomes possible to cut high hard material such as quenched steel.

By the way, recently, there have been demands for realizing cutting much harder material (for example, high hardness quenched material or the like). A hard coating film has been proposed by Japanese Patent Nos. 3,248,897 and 3,248,898 where a TiAlN system coating film and a TiSiN system coating film are laminated one on another and by Japanese Patent Nos. 3,343,727 and 3,347,687 where a TiN system coating film is used in combination with and in addition to the TiAlN system coating film and the TiSiN system coating film.

However, it is impossible to say that the anti-wear property is satisfactory for cutting high hardness quenched steel represented by SKD 11 or the like. The development of the hard coating film for a cutting tool which is much superior in anti-wear property is to be demanded.

The present inventors and the like have studied the structure of the coating film and the composition of the coating film and have found that the above-noted problems may be solved by enhancing lubrication and anti-oxidation property of the hard coating film. On the basis of this finding, by enhancing the anti-wear property in comparison with the conventional case, it becomes possible to provide a hard coating film for a cutting tool which is superior in anti-wear property for the high hardness quenched steel represented by SKD 11 or the like which has conventionally been unsatisfactory.

### Means for solving the Problems

The invention is directed to a hard coating film provided for a cutting tool as defined in claim 1 and a method for forming the hard coating film as defined in claim 8.

Preferred embodiments of the invention are defined in the dependent claims.

### Operation and Effect of the Invention

According to the present invention, the first coating film that is superior in contacting property with the base material is provided directly on the surface of the base material and the second coating film that is superior in anti-oxidation property and lubrication and having a high hardness is provided as the uppermost layer. Not only can the cutting tool provided with the coating film having this structure conduct a good cutting work but also the wear of the cutting tool may be prevented as much as possible to prolong a service lift of the cutting tool even if the cutting operation is effected to the high hardness material to be cut such as high hardness quenched steel.

Accordingly, according to the present invention, it is possible to provide a hard coating film for a cutting tool which is superior in practical use with extremely excellent durability.

### Mode of the Invention

An embodiment of the invention is directed to a hard coating film provided for a cutting tool characterized in that a first coating film containing Ti as a metal element and one or two of N and C as non-metal elements is provided directly on a surface of a base material, and a second coating film in which metal and semi-metal compositions are nitride, carbon nitride, oxygen nitride or carbon oxygen nitride represented in terms of % by atom by:

Ti_{(100-X-Y)}Cr_{(X)}Si_{(Y)}

where X: 10≦5Cr≦30, Y: 10≦Si≦40 is provided as an uppermost layer.

The reason why the composition of the second coating film is defined by the above-described range is as follows.

The present inventors and the like tried to add various kinds of third elements to the TiSiN system hard film and had found that it was possible to enhance the anti-oxidation and the lubrication by containing a predetermined amount of Cr.

Namely, it was confirmed that in the case where the amount of Cr did not reach 10% in terms of % by atom only in metal and semi-metal, its effect was small but in case of 10% or more, the enhance effect of the anti-oxidation and the lubrication was exhibited and the anti-wear effect against high hardness material to be cut by the cutting tool coated by the coating film was enhanced.

Also, it was confirmed that if the excessive amount of Cr was added, the hardness of the coating film was degraded and the anti-wear property against the high hardness material to be cut by the cutting tool which was coated by the coating film.

On the other hand, with respect to the containment of Si, if the amount of Si is increased, the anti-oxidation and the hardness are enhanced.

Namely, it was confirmed that in the case where the amount of Si did not reach 10% in terms of % by atom only in metal and semi-metal, its effect was small but in case of 10% or more, the enhance effect of the anti-oxidation and the hardness was exhibited and the anti-wear effect against high hardness material to be cut by the cutting tool coated by the coating film was enhanced.

Also, it was confirmed that if the excessive amount of Si was added, an internal stress of the coating film was increased so that a crack was generated in the coating film and the anti-wear property against the high hardness material to be cut by the cutting tool coated by the coating film was degraded.

In view of the above, in the present embodiment, the composition range of the second coating film was set so that the amount of Cr was not less than 10% but not more than 30% in terms of % by atom only in metal and semi-metal in order to establish not only the anti-oxidation of the hard coating material for the cutting tool but also the lubrication and the hardness thereof, and the amount of Si was not less than 10% but not more than 40% in terms of % by atom only in metal and semi-metal in order to establish not only the anti-oxidation and hardness of the hard coating material for the cutting tool but also the internal stress thereof.

Furthermore, if a minute amount of the elements of B, V, Y, Zr, Nb, Mo, Hf, Ta and W is added, the hardness and the anti-oxidation of the coating film was further enhanced. For this reason, it is desirable to add a minute amount of one kind or two or more kinds of these elements by, for example, 2 to 5% by atom.

The reason why the composition of the first coating film is the TiCN system coating film is as follows.

In cutting high hardness material to be cut using water soluble cutting oil or non-water soluble cutting oil, the tool is subjected to a remarkable heat cycle (heat shock). In the case where a TiAlN system coating film layer is formed on a surface of the cutting tool composed of super hard alloy base, there is a problem that the above-described TiAlN system coating film layer is peeled off due to the thermal stress generated between the above-described super hard alloy base and the TiAlN system coating film layer so that the anti-wear property of the cutting tool is degraded (that is, the contactability is degraded).

Also, in the case where the TiN system coating film that is superior in contactability is provided between the above-described TiAlN system coating film and the super hard alloy base as described in Japanese Patent Nos. 3,343,727 and 3,347,687, it is possible to suppress the degradation of the anti-wear property in cutting the high hard material using the cutting oil as described above, but in order to form the multiple layer coating film by a physical evaporation method such as an arc discharge type ion plating method and a sputtering method, it is necessary to use three kinds of targets of a Ti system target, a TiAl system target and TiSi system target separately and it is inevitable to increase the cost therefor.

Accordingly, the present inventors and the like adopt the TiCN system coating film which may form the first coating film and the second coating film by the two kinds of targets which are superior in contactability with the base and has past records in anti-wear property under the cutting oil condition as the coating film provided on the surface of the super hard alloy base.

The TiCN system coating film has a satisfactory hardness as 3,000 to 3,500HV in terms of Vickers hardness but has a defect that the anti-oxidation is low. However, the present inventors and the like have confirmed that the degradation of the anti-oxidation of the TiCN system coating film is diluted by laminating onto the TiCN system coating film the coating film that is superior in anti-oxidation and the anti-oxidation of the coating film as a whole follows the coating film of the uppermost layer.

Also, in order to further enhance the contactability between the coating film and the base, it is desirable to gradually (continuously) increase an amount of C from the surface of the base to the interior of the coating film. Incidentally, it is possible to enhance the contactability between the coating film and the base by forming a part where the amount of C is large and a part where the amount of C is small (discontinuously) in the coating film rather than by gradually changing the amount of C in the coating film.

Also, it is possible to adopt the TiN system coating film that is much superior in contactability with the base or the TiC system coating film that may be less expensively formed without adopting the TiCN system coating film as the first coating film.

Furthermore, since, if a minute amount of the elements of B, V, Cr, Y, Zr, Nb, Mo, Hf, Ta and W is added, the hardness and the anti-oxidation of the coating film was further enhanced, it is desirable to add a minute amount of one kind or two or more kinds of these elements by, for example, 2 to 5% by atom.

As described above, if the amount of Si is large in the second coating film, the internal stress is increased but it is desirable to form between the first coating film and the second coating film the intermediate coating film which is formed by mixing the two kinds of coating film compositions in order to suppress the internal stress thereof.

For example, in the physical evaporation method such as an arc discharge ion plating method or a sputtering method, it is possible to form the intermediate coating film by the following method.

Namely, the Ti system target forming the coating film composition of the first coating film and the TiCrSi system target forming the coating film composition of the second coating film are arranged on the right and left sides within the film forming apparatus and a cutting tool is set so that a coating film is coated in an intermediate position therebetween.

Next, two kinds of targets work simultaneously to discharge ion and at the same time, the cutting tool is rotated about an axis perpendicular to a line connecting the two kinds of the targets.

Thus, the extremely thin first intermediate coating film and the extremely thin second intermediate coating film are laminated alternatively. As a result, the first intermediate coating film having the same composition as that of the first coating film and the second intermediate coating film having the same composition as that of the second coating film are laminated alternatively to form the intermediate coating film.

Also, it is desirable that the film thickness of the first intermediate coating film and the second intermediate coating film is not greater than 0.2 µm. This is because, if the film thickness is greater than 0.2 µm, the internal stress in the intermediate coating film is non-uniform in the film thickness direction and it is likely that a crack would be generated in the coating film.

Furthermore, in order to form the coating film characteristics such as the internal stress, the hardness or the like in a stable manner with excellent reproduction, it is desirable to form the coating films (the second coating film and the first and the second intermediate coating films), except the first coating film, while keeping ion energy generated upon the formation of the coating films constant in each coating film.

A specific embodiment of the present invention will now be described in more detail.

An arc discharge type ion plating apparatus was used as a film forming apparatus. Targets for respective kinds of composition were mounted within the film forming apparatus as evaporation sources for metal and semi-metal constituents. Also, one or two kinds of N₂ gas, CH₄ gas and N₂/O₂ mixture gas as reactive gas were introduced into the film forming apparatus and a predetermined coating film was formed in a two blade ball end mill (outer diameter of 3 mm) made of super hard alloy as the film forming base.

Upon forming the film, the film was formed on the above-described end mill so that the film thickness of the film as a whole was in the range of 2.3 to 2.8 µm under the condition that the base material temperature was 450°C, the gas pressure was 3.0Pa and the bias voltage was -100V (i.e., while keeping the ion energy constant upon forming the coating film).

The cutting experiment was conducted under the following tow cutting condition by using the above-described end mill coated with a predetermined coating film and the wear width of the end mill escape surface was measured.

In the first cutting experiment, the cutting material was SKD 11 quenched material (60HRC) and the cutting was conducted under a dry type condition.

The end mill having the outer diameter of 3mm was rotated at an RPM of 19,000 min⁻¹ and the experiment was conducted using air blow as coolant while the feed speed was 1,440mm/min, the cutting amount Ad was 0.15mm and Pf was 0.45mm.

The result of the cutting experiment is shown in Table 1. The result in which the conventional hard coating film and the hard coating film falling out of the range of the present invention were subjected to the cutting experiment by the end mill coated by the means similar to that of the embodiment was described as comparisons.

**Table 1**

| No. | 1st coating film | | Intermediate coating film | | 2nd coating film | | Escapce surface wear width (mm) | Note |
|---|---|---|---|---|---|---|---|---|
| | Composition | Film thickness (µm) | Composition | Film thickness (µm) | Composition | Film thickness (µm) | | |
| 1 | TiCN | 1.2 | - | - | (Ti₆₃Cr₁₂Si₂₅)N | 1.2 | 0.091 | Emb |
| 2 | TiCN | 1.2 | - | - | (Ti₆₀Cr₁₇Si₂₃)N | 1.2 | 0.082 | Emb |
| 3 | TiCN | 1.2 | - | - | (Ti₅₃Cr₂₂Si₂₅)N | 1.2 | 0.092 | Emb |
| 4 | TiCN | 1.2 | - | - | (Ti₅₀Cr₂₆Si₂₄)N | 1.2 | 0.108 | Emb |
| 5 | TiCN | 1.2 | - | - | (Ti₆₆Cr₂₃Si₁₁)N | 1.2 | 0.102 | Emb |
| 6 | TiCN | 1.2 | - | - | (Ti₆₀Cr₂₃Si₁₇)N | 1.2 | 0.084 | Emb |
| 7 | TiCN | 1.2 | - | - | (Ti₄₃CT₂₁Si₃₆)N | 1.2 | 0.110 | Emb |
| 8 | TiCN | 1.2 | - | - | (Ti₅₆Cr₁₇Si₂₃Hf₄)N | 1.2 | 0.086 | Emb |
| 9 | TiCN | 1.2 | - | - | (Ti₅₅Cr₁₇Si₂₃Y₅)N | 1.2 | 0.082 | Emb |
| 10 | (Ti₉₅Cr₅)CN | 1.2 | - | - | (Ti₆₀Cr₁₇Si2₃)N | 1.2 | 0.092 | Emb |
| 11 | TiCN | 1.2 | - | - | (Ti₆₀Cr₁₇Si₂₃)CN | 1.2 | 0.107 | Emb |
| 12 | TiCN | 1.2 | - | - | (Ti₆₀Cr₁₇Si₁₇)ON | 1.2 | 0.118 | Emb |
| 13 | TiCN | 1.2 | - | - | (Ti₆₀Cr₁₇Si₂₃)CON | 1.2 | 0.122 | Emb |
| 14 | TiCN | 1.0 | mix. | 0.6 | (Ti₆₀Cr₁₇Si₂₃)N | 1.0 | 0.084 | Emb |
| 15 | TiCN | 1.0 | mix. | 0.6 | (Ti₆₀Cr₂₃Si₁₇)N | 1.0 | 0.088 | Emb |
| 16 | TiCN | 1.0 | mix | 0.6 | (Ti₄₃Cr₂₁Si₃₆)N | 1.0 | 0.102 | Emb |
| 17 | TiCN | 1.0 | mix | 0.6 | (Ti₆₀Cr₁₇Si₂₃)CN | 1.0 | 0.106 | Emb |
| 18 | (Ti₅₀Al₅₀)N | 1.2 | - | - | (Ti₆₀Cr₁₇Si₂₃)N | 1.2 | 0.096 | Com |
| 19 | (Ti₅₀Al₅₀)N | 1.2 | - | - | (Ti₇₇Si₂₃)N | 1.2 | 0.122 | Com |
| 20 | TiCN | 1.2 | - | - | (Ti₃₉Cr₃₈Si₂₃)N | 1.2 | 0.125 | Com |
| 21 | (Ti₅₀Al₅₀)N | 2.5 | - | - | - | - | 0.186 | Com |

From Table 1, in the embodiment, the reduction of the wear width of the escape surface of the end mill, i.e. the enhancement of the anti-wear property is admitted in comparison with the comparisons. Incidentally, the remarkable difference of the coating film of No. 18 from the present embodiment is not admitted in the condition of the cutting experiment shown in the Table 1, i.e., the cutting operation under the dry condition.

As a second cutting experiment, the cutting was performed under the wet type condition while using the material to be cut was SKD 61 quenched material (50HRC).

The end mill having the outer diameter of 3mm was rotated at an RPM of 20,000 min⁻¹ and the experiment was conducted using water soluble cutting oil as coolant while the feed speed was 1,680mm/min, the cutting amount Ad was 0.24mm and Pf was 0.72mm. The result of the cutting experiment is shown in Table 2.

**Table 2**

| No. | 1st coating film | | Intermediate coating film | | 2nd coating film | | Escapce surface wear width (mm) | Note |
|---|---|---|---|---|---|---|---|---|
| | Composition | Film thickness (µm) | Composition | Film thickness (µm) | Composition | Film thickness (µm) | | |
| 1 | TiCN | 1.2 | - | - | (Ti₆₃Cr₁₂Si₂₅)N | 1.2 | 0.114 | Emb |
| 2 | TiCN | 1.2 | - | - | (Ti₆₀Cr₁₇Si₂₃)N | 1.2 | 0.105 | Emb |
| 3 | TiCN | 1.2 | - | - | (Ti₅₃Cr₂₂Si₂₅)N | 1.2 | 0.108 | Emb |
| 4 | TiCN | 1.2 | - | - | (Ti₅₀Cr₂₆Si₂₄)N | 1.2 | 0.122 | Emb |
| 5 | TiCN | 1.2 | - | - | (Ti₆₆Cr₂₃Si₁₁)N | 1.2 | 0.120 | Emb |
| 6 | TiCN | 1.2 | - | - | (Ti₆₀Cr₂₃Si₁₇)N | 1.2 | 0.102 | Emb |
| 7 | TiCN | 1.2 | - | - | (Ti₄₃Cr₂₁Si₃₆)N | 1.2 | 0.123 | Emb |
| 8 | TiCN | 1.2 | - | - | (Ti₅₆Cr₁₇Si₂₃Hf₄)N | 1.2 | 0.102 | Emb |
| 9 | TiCN | 1.2 | | - | (Ti₅₅Cr₁₇Si₂₃Y₅)N | 1.2 | 0.098 | Emb |
| 10 | (Ti₉₅Cr₅)CN | 1.2 | - | - | (Ti₆₀Cr₁₇Si₂₃)N | 1.2 | 0.114 | Emb |
| 11 | TiCN | 1.2 | - | - | (Ti₆₀Cr₁₇Si₂₃)CN | 1.2 | 0.128 | Emb |
| 12 | TiCN | 1.2 | - | - | (Ti₆₀Cr₁₇Si₂₃)ON | 1.2 | 0.132 | Emb |
| 13 | TiCN | 1.2 | - | - | (Ti₆₀Cr₁₇Si₂₃)CON | 1.2 | 0.126 | Emb |
| 14 | TiCN | 1.0 | mix. | 0.6 | (Ti₆₀Cr₁₇Si₂₃)N | 1.0 | 0.092 | Emb |
| 15 | TiCN | 1.0 | mix. | 0.6 | (Ti₆₀Cr₂₃Si₁₇)N | 1.0 | 0.088 | Emb |
| 16 | TiCN | 1.0 | mix | 0.6 | (T1₄₃Cr₂₁Si₃₆)N | 1.0 | 0.096 | Emb |
| 17 | TiCN | 1.0 | mix | 0.6 | (Ti₆₀Cr₁₇Si₂₃)CN | 1.0 | 0.106 | Emb |
| 18 | (Ti₅₀Al₅₀)N | 1.2 | - | - | (Ti₆₀Cr₁₇Si₂₃)N | 1.2 | 0.215 | Com |
| 19 | (Ti₅₀Al₅₀)N | 1.2 | - | - | (Ti₇₇Si₂₃)N | 1.2 | 0.210 | Com |
| 20 | TiCN | 1.2 | - | - | (Ti₃₉Cr₃₈Si₂₃)N | 1.2 | 0.133 | Com |
| 21 | (Ti₅₀Al₅₀)N | 2.5 | - | - | - | - | 0.330 | Com |

From Table 2, in the embodiment, the remarkable reduction of the wear width of the escape surface of the end mill, i.e. the enhancement of the remarkable anti-wear property even under the wet type condition is admitted in comparison with the comparisons.

Accordingly, in the embodiment, not only may the excellent anti-wear property be exhibited even under the above-described dry type condition but also the anti-wear property may be exhibited under the wet type condition under which the good anti-wear property may not be obtained in the conventional case.

## Claims

1. A hard coating film provided for a cutting tool **characterized in that** a first coating film containing Ti as a metal element and one or two of N and C as non-metal elements is provided directly on a surface of a base material, and a second coating film in which metal and semi-metal compositions are nitride, carbon nitride, oxygen nitride or carbon oxygen nitride represented in terms of % by atom by:
Ti_{(100-X-Y)}Cr_{(X)}Si_{(Y)}
where X: 10≦Cr≦30, Y: 10≦Si≦40
is provided as an uppermost layer.

2. The hard coating film for the cutting tool according to claim 1, **characterized in that** the second coating layer is provided on the first coating layer.

3. The hard coating film for the cutting tool according to claim 1, **characterized in that** at least two layers of a second intermediate coating film which has the same composition as that of the second coating film and a first intermediate coating film which has the same composition as that of the first coating film are laminated alternatively.

4. The hard coating film for the cutting tool according to claim 3, **characterized in that** at least two layers of the second intermediate coating film having a film thickness of 0.2 µm or less and the first intermediate coating film having a film thickness of 0.2 µm or less are laminated alternatively.

5. The hard coating film for the cutting tool according to any one of claims 1 to 4, **characterized in that** a rate of content of the non-metal element in the first coating film is changed continuously or discontinuously in the first coating film.

6. The hard coating film for the cutting tool according to any one of claims 1 to 5, **characterized in that** a part of Ti in the first coating film is replaced by one or at least two elements of B, V, Cr, Y, Zr, Nb, Mo, Hf, Ta and W in the range of 10% or less in terms of % by atom.

7. The hard coating film for the cutting tool according to any one of claims 1 to 6, **characterized in that** a part of Ti in the second coating film is replaced by one or at least two elements of B, V, Y, Zr, Nb, Mo, Hf, Ta and W in the range of 10% or less in terms of % by atom.

8. A method for forming the hard coating film for the cutting tool according to any one of claims 1 to 7, **characterized in that** the first coating film and the second coating film are formed in a physical evaporation manner and the coating films other than the first coating film is formed while an ion energy upon the formation of the coating film is kept constant in each coating film.

## Patentansprüche

1. Eine harte Überzugsschicht vorgesehen für ein Schneidwerkzeug, **dadurch gekennzeichnet, dass** eine erste Überzugsschicht, die Ti als ein metallisches Element und eines oder zwei von N und C als nicht-metallische Elemente enthält, direkt auf einer Oberfläche eines Basismaterials vorgesehen ist, und eine zweite Überzugsschicht in welcher metallische und halbmetallische Zusammensetzungen Nitrid, Carbonnitrid, Sauerstoffnitrid oder Carbonsauerstoffnitrid sind repräsentiert gemäß % von Atomen durch:
Ti_{(100-X-Y)}Cr_{(X)}Si_{(Y)}
wobei X: 10≤Cr≤30, Y: 10≤Si≤40
als oberste Schicht vorgesehen ist.

2. Die harte Überzugsschicht für das Schneidwerkzeug gemäß Anspruch 1, **dadurch gekennzeichnet, dass** die zweite Überzugsschicht auf der ersten Überzugsschicht vorgesehen ist.

3. Die harte Überzugsschicht für das Schneidwerkzeug gemäß Anspruch 1, **dadurch gekennzeichnet, dass** wenigstens zwei Schichten einer zweiten dazwischenliegenden Überzugsschicht, die die gleiche Zusammensetzung wie die zweite Überzugsschicht und einer ersten dazwischenliegende Überzugsschicht, die die gleiche Zusammensetzung wie die erste Überzugsschicht hat, wechselweise laminiert sind.

4. Die harte Überzugsschicht für das Schneidwerkzeug gemäß Anspruch 3, **dadurch gekennzeichnet, dass** wenigstens zwei Schichten der zweiten dazwischenliegenden Überzugsschicht, die eine Schichtdicke von 0,2 µm oder weniger hat, und der ersten dazwischen liegenden Überzugsschicht, die eine Schichtdicke von 0,2 µm oder weniger hat, wechselweise laminiert sind.

5. Die harte Überzugsschicht für das Schneidwerkzeug gemäß einem der Ansprüche 1 bis 4, **dadurch gekennzeichnet, dass** der Anteil des nicht-metallischen Elements in der ersten Überzugsschicht kontinuierlich oder diskontinuierlich in der ersten Überzugsschicht geändert wird.

6. Die harte Überzugsschicht für das Schneidwerkzeug gemäß einem der Ansprüche 1 bis 5, **dadurch gekennzeichnet, dass** ein Teil des Ti in der ersten Überzugsschicht durch eines oder wenigstens zwei der Elemente B, V, Cr, Y, Zr, Nb, Mo, Hf, Ta und W im Bereich von 10% oder weniger gemäß % von Atomen ersetzt wird.

7. Die harte Überzugsschicht für das Schneidwerkzeug gemäß einem der Ansprüche 1 bis 6, **dadurch gekennzeichnet, dass** ein Teil des Ti in der zweiten Überzugsschicht durch eins oder wenigstens zwei der Elemente B, V, Y, Zr, Nb, Mo, Hf, Ta und W im Bereich von 10% oder weniger gemäß % von Atomen ersetzt wird.

8. Ein Verfahren zum Ausbilden der harten Überzugsschicht für das Schneidwerkzeug gemäß einem der Ansprüche 1 bis 7, **dadurch gekennzeichnet, dass** die erste Überzugsschicht und die zweite Überzugsschicht nach einer physikalischen Verdampfungsweise ausgebildet werden und die anderen Überzugsschichten als die erste Überzugsschicht geformt werden während eine Ionisierungsenergie auf das Ausbilden der Überzugsschicht in jeder Überzugsschicht konstant gehalten wird.

## Revendications

1. Film de revêtement dur prévu pour un outil de coupe, **caractérisé en ce qu'**un premier film de revêtement, contenant du Ti en tant qu'élément métallique et l'un ou les deux de N et de C en tant qu'éléments non métalliques, est disposé directement sur une surface d'une matière de base, et **en ce qu'**un second film de revêtement dans lequel des compositions métalliques et semi-métalliques sont du nitrure, du nitrure de carbone, du nitrure d'oxygène ou de l'oxynitrure de carbone représentées en termes de % en atomes par :
Ti_{(100-X-Y)}Cr_{(X)}S_{(Y)}
où X : 10 ≤ Cr ≤ 30, Y : 10 ≤ Si ≤ 40 40
est prévu en tant que couche supérieure.

2. Film de revêtement dur pour outil de coupe selon la revendication 1, **caractérisé en ce que** la seconde couche de revêtement est disposée sur la première couche de revêtement.

3. Film de revêtement dur pour outil de coupe selon la revendication 1, **caractérisé en ce qu'**au moins deux couches d'un second film de revêtement intermédiaire, qui a la même composition que celle du second film de revêtement, et d'un premier film de revêtement intermédiaire, qui a la même composition que celle du premier film de revêtement, sont stratifiées en alternance.

4. Film de revêtement dur pour outil de coupe selon la revendication 3, **caractérisé en ce qu'**au moins deux couches du second film de revêtement intermédiaire ayant une épaisseur de film de 0,2 µm ou moins et du premier film de revêtement intermédiaire ayant une épaisseur de film de 0,2 µm ou moins sont stratifiées en alternance.

5. Film de revêtement dur pour outil de coupe selon l'une quelconque des revendications 1 à 4, **caractérisé en ce que** la valeur de la teneur de l'élément non métallique dans le premier film de revêtement est changée continuellement ou de manière discontinue dans le premier film de revêtement.

6. Film de revêtement dur pour outil de coupe selon l'une quelconque des revendications 1 à 5, **caractérisé en ce qu'**une partie du Ti dans le premier film de revêtement est remplacée par un ou au moins deux éléments parmi B, V, Cr, Y, Zr, Nb, Mo, Hf, Ta et W dans la plage de 10 % ou moins en termes de % en atomes.

7. Film de revêtement dur pour outil de coupe selon l'une quelconque des revendications 1 à 6, **caractérisé en ce qu'**une partie du Ti dans le second film de revêtement est remplacée par un ou au moins deux éléments parmi B, V, Y, Zr, Nb, Mo, Hf, Ta et W dans la plage de 10 % ou moins en termes de % en atomes.

8. Procédé de formation du film de revêtement dur pour outil de coupe selon l'une quelconque des revendications 1 à 7, **caractérisé en ce que** le premier film de revêtement et le second film de revêtement sont formés par évaporation physique et **en ce que** les films de revêtement autres que le premier film de revêtement sont formés tandis qu'une énergie ionique lors de la formation du film de revêtement est conservée constante dans chaque film de revêtement.
